# EUROPÄISCHE PATENTSCHRIFT

(11) **EP 3 507 241 B1**
(45) Veröffentlichungstag und Bekanntmachung des Hinweises auf die Patenterteilung: **09.03.2022**
(21) Anmeldenummer: 17764531.4
(22) Anmeldetag: 28.08.2017
(51) Int. Cl.: C01B 25/08, H01L 35/14, H01L 35/20

(54) **THERMOELEKTRISCHES MATERIAL**
THERMOELECTRIC MATERIAL
MATÉRIAU THERMOÉLECTRIQUE

(30) Priorität: 31.08.2016 DE 102016116248
(43) Veröffentlichungstag der Anmeldung: 10.07.2019
(73) Patentinhaber: Technische Universität Darmstadt, 64289 Darmstadt (DE)
(72) Erfinder: ALBERT, Barbara, 64285 Darmstadt (DE); HENGE, Dennis, 64293 Darmstadt (DE)
(74) Vertreter: Fuchs Patentanwälte Partnerschaft mbB
(86) Internationale Anmeldenummer: PCT/EP2017/071570
(87) Internationale Veröffentlichungsnummer: WO 2018/041788

(56) Entgegenhaltungen:
- PONNAMBALAM V ET AL: "High Seebeck coefficient AMXP2 (A = Ca and Yb; M, X = Zn, Cu and Mn) Zintl phosphides as high-temperature thermoelectric materials;High Seebeck coefficient AMXP2 (A = Ca and Yb; M, X = Zn, Cu and Mn) Zintl phosphides as high-temperature thermoelectric materials", JOURNAL OF PHYSICS D: APPLIED PHYSICS, INSTITUTE OF PHYSICS PUBLISHING LTD, GB, Bd. 44, Nr. 15, 28. März 2011 (2011-03-28) , Seite 155406, XP020188359, ISSN: 0022-3727, DOI: 10.1088/0022-3727/44/15/155406
- PONNAMBALAM V ET AL: "Thermoelectric Properties of Light-Element-Containing Zintl Compounds CaZn2-xCuxP2and CaMnZn1-xCuxP2(x = 0", JOURNAL OF ELECTRONIC MATERIALS, WARRENDALE, PA, US, Bd. 43, Nr. 6, 19. November 2013 (2013-11-19), Seiten 1875-1880, XP035314124, ISSN: 0361-5235, DOI: 10.1007/S11664-013-2895-2 [gefunden am 2013-11-19]
- GUECHI N ET AL: "Structural, elastic, electronic and optical properties of the newly synthesized monoclinic Zintl phase BaIn2P2", SOLID STATE SCIENCES, ELSEVIER, PARIS, FR, Bd. 29, 13. Januar 2014 (2014-01-13), Seiten 12-23, XP028661238, ISSN: 1293-2558, DOI: 10.1016/J.SOLIDSTATESCIENCES.2014.01.001
- JAPHETH F. RAUSCHER ET AL: "Flux growth and structure of two compounds with the EuIn2P2 structure type, AIn2P2 ( A = Ca and Sr), and a new structure type, BaIn2P2", ACTA CRYSTALLOGRAPHICA SECTION C. CRYSTAL STRUCTURE COMMUNICATIONS, Bd. C65, Nr. 10, 30. September 2009 (2009-09-30), Seiten i69-i73, XP055414560, DK ISSN: 0108-2701, DOI: 10.1107/S0108270109035987

## Beschreibung

Gegenstand dieser Erfindung ist ein thermoelektrisches Material, ein Verfahren zu seiner Herstellung und seine Verwendung.

### Stand der Technik

Thermoelektrische Materialien sind aus dem Stand der Technik bekannt. Sie wandeln aufgrund des Seebeck-Effektes Wärme in elektrische Energie um. So kann beispielsweise Abwärme im Abgasstrang eines Kraftfahrzeugs genutzt werden, um Kraftstoff zu sparen. Allerdings werden hierzu preiswerte, nicht toxische, möglichst leichte Materialien benötigt, die im richtigen Temperaturbereich möglichst effizient Wärme in Strom umwandeln. Ein ideales Thermoelektrikum sollte nicht luft- oder feuchtigkeitsempfindlich sein, eine vergleichsweise geringe Dichte haben und aus kostengünstigen Rohstoffen herstellbar sein. Ferner sollte das Material einen hohen Seebeck-Koeffizienten, einen niedrigen elektrischen Widerstand und eine geringe Wärmeleitfähigkeit aufweisen, so dass eine hohe thermoelektrische Gütezahl (zT-Faktor) resultiert.

Bisher eingesetzte Materialien enthalten Elemente, die toxisch (Blei), schlecht verfügbar und teuer (Tellur, Germanium, Ytterbium, Bismut) und schwer (Bismut, Blei) sind. Im Temperaturbereich von 400 °C bis 700 °C besitzen einige Heusler-Verbindungen gute thermoelektrische Eigenschaften. Sie bestehen jedoch aus exotischen, komplizierten Elementkombinationen (z.B. Hafnium). Einige Phosphide sind als Substanz bekannt und teilweise auch thermoelektrisch charakterisiert. Phosphide werden allerdings bislang nicht als Thermoelektrika genutzt, weil ausreichende thermoelektrische Eigenschaften nicht erreicht werden.

So beschreibt etwa Ponnambalam et al. (High Seebeck coefficient AMXP2 (A=Ca and Yb; M, X = Zn, Cu and Mn) Zintl phosphides as high-temperature thermoelectric materials. In: J. Phys. D: Appl. Phys. 44(2011*)*) Zintl-Phosphide als Thermoelektrika. Untersucht wurden Phosphide der Stöchiometrie AMXP₂ mit A = Ca und Yb; M, X = Zn, Cu und Mn), nämlich CaZn₂P₂, YbZn₂P₂, YbCuZnP₂ und YbMnCuP₂. Die dort beschriebenen Phosphide enthalten mit Ytterbium allerdings ein sehr teures Element. Das ebenfalls untersuchte CaZn₂P₂ hingegen hat bei den relevanten Temperaturen einen sehr großen elektrischen Widerstand (100 mΩ*cm bei 1000 K), was für thermoelektrische Anwendungen gänzlich ungeeignet ist. Yb wird als notwendig für gute zT-Faktoren beschrieben. Für YbCuZnP₂ wurde ein zT-Wert von ca. 0,6 ermittelt. Die anderen Verbindungen haben zu wesentlich schlechteren Ergebnissen geführt.

Ferner beschreibt Ponnambalam, V. et al. in "Thermoelectric Properties of Light-Element-Containing Zintl Compounds CaZn2-xCuxP2 and CaMnZn1-xCuxP2 (x = 0.0-0.2)", In: J. Electron. Mater., Vol. 43, No. 6, 2014, S. 1875-1880 Leichtelemente enthaltende Zintlphasen des CaAl₂Si₂ Typs. Es wurden CaZn₂₋ₓCuₓP₂ and CaMnZn₁₋ₓCuₓP₂ (x = 0.0-0.2) in einer Festphasenreaktion synthetisiert und deren spezifischer elektrischer Widerstand, Seebeck Koeffizient und thermische Leitfähigkeit über den Bereich 80-1000 K gemessen. Es wurde für den zT-Wert ein Maximum von 0,4 bei CaZn_{1,9}Cu_{0,1}P₂ gefunden.

US 7,728,218 B2 beschreibt hocheffiziente thermoelektrische Zintl-Phasen. Die dort beschriebenen Materialien weisen teilweise sehr hohe thermoelektrische Gütezahlen auf. Allerdings sind die Materialien aufgrund ihres Gehaltes an Antimon im Hinblick auf ihre Toxizität bedenklich. Ferner enthalten die Materialien große Mengen an Ytterbium, so dass sehr teure Rohstoffe für die Herstellung verwendet werden müssen. Darüber hinaus zeigt sich, dass in dem Dokument beschriebene Materialien erst bei vergleichsweise hoher Temperatur die beschriebenen Gütezahlen erreichen. Ferner weisen die dort beschriebenen Verbindungen relativ hohe Dichten auf, die annähernd doppelt so hoch sind wie die Dichten der hier erfindungsgemäßen Verbindungen. Hohe Dichten stehen einer industriellen Verwendung entgegen, da mehr Material auf gleicher Fläche benötigt wird. Gerade in dem Temperaturbereich oberhalb von 400 °C (insbesondere bis 700 °C) fehlt es an geeigneten thermoelektrischen Materialien, insbesondere an solchen mit geringer Dichte.

Guechi, N. et al. ("Structural, elastic, electronic and optical properties of the newly synthesized monoclinic Zintl phase Baln2P2", In: Solid State Sci., Vol. 29, 2014, S. 12-23) haben die monokline Zintl Phase Baln₂P₂ untersucht. Dabei wurde eine gute Übereinstimmung zwischen den berechneten Gitterkonstanten und internen Koordinaten und den experimentellen Ergebnissen gefunden. Ferner wurde die elektronische Bandstruktur unter hydrostatischem Druck untersucht.

### Aufgabe

Es besteht mithin ein Bedarf an thermoelektrischen Materialien, die einen hohen Seebeck-Koeffizienten, geringe Wärmeleitfähigkeit und geringen elektrischen Widerstand bei ungiftigen Inhaltsstoffen, geringer Dichte und günstigen Rohstoffen miteinander vereinen. Ferner sollen die Materialien bei mittleren (z.B. für Kraftfahrzeuge) und hohen Temperaturen oberhalb 400 °C gute thermoelektrische Eigenschaften haben.

### Lösung

Diese Aufgabe wird durch die Gegenstände der Patentansprüche gelöst.

### Material

Die Erfindung betrifft ein thermoelektrisches Material mit der Formel

R₁₋ₓMnₓCuP

wobei x wenigstens 0,01 und höchstens 0,99 beträgt und R ausgewählt ist aus Magnesium, Calcium, Strontium, Barium und Mischungen daraus.

Es hat sich gezeigt, dass Vertreter dieser Materialklasse nicht nur wenig luft- und feuchtigkeitsempfindlich sind, sondern auch im Vergleich zu den thermoelektrischen Materialien des Standes der Technik eine geringe Dichte aufweisen und hohe thermoelektrische Gütezahlen im Temperaturbereich von 400 °C bis 700 °C erreichen. Diese Verbindungen sind aus dem Stand der Technik bisher nicht bekannt.

Es wurde gefunden, dass die thermoelektrischen Eigenschaften des Materials weiter verbessert werden können, wenn x nicht mehr als 0,5, insbesondere nicht mehr als 0,3 oder nicht mehr als 0,2 beträgt. Weitere Verbesserungen treten ein, wenn x wenigstens 0,02, weiter bevorzugt wenigstens 0,03 und besonders bevorzugt wenigstens 0,08 beträgt. Insbesondere beträgt x vorzugsweise von 0,02 bis 0,5; bevorzugt von 0,03 bis 0,3 und besonders bevorzugt von 0,03 bis 0,2.

Die besten Ergebnisse wurden erzielt, wenn R Magnesium ist. Besonders bevorzugte Verbindungen dieser Erfindung sind Mg_{0,9}Mn_{0,1}CuP, Mg_{0,85}Mn_{0,15}CuP und Mg_{0,8}Mn_{0,2}CuP.

In bevorzugten Ausführungsformen erreichen die genannten Verbindungen in einem Temperaturbereich ab 400 °C (insbesondere bis 700 °C) eine thermoelektrische Gütezahl von wenigstens 0,4, insbesondere wenigstens 0,6, bevorzugt wenigstens 0,7 auf. In bevorzugten Ausführungsformen beträgt der Seebeck-Koeffizient der Materialien in einem Temperaturbereich ab 400 °C (insbesondere bis 700 °C) wenigstens 80 µV/K, insbesondere wenigstens 120 µV/K, weiter bevorzugt wenigstens 140 µV/K und besonders bevorzugt wenigstens 160 µV/K in einem Temperaturbereich ab 400 °C bis 700 °C. Vorzugsweise beträgt die Dichte der Materialien bei 20 °C vorzugsweise weniger als 5,5 g/cm³, insbesondere weniger als 4,8 g/cm³ und bevorzugt weniger als 4,7 g/cm³. Die angegebenen Merkmale treffen insbesondere auch auf aus dem Material hergestellte Formkörper zu, die ebenfalls erfindungsgemäß sind. Damit sind die Thermoelektrika dieser Erfindung leichter als viele Materialien im Stand der Technik. Ferner weisen die verwendeten Rohstoffe, nämlich die Erdalkalimetalle (ohne Barium), Mangan, Kupfer und Phosphor vergleichsweise geringe Toxizität auf.

Das erfindungsgemäße Material weist vorzugsweise im Temperaturbereich ab 400 °C (insbesondere bis 700 °C) Wärmeleitfähigkeiten von höchstens 3,5 W/mK, insbesondere höchstens 2,5 W/mK, bevorzugt höchstens 2,4 W/mK und besonders bevorzugt höchstens 2,3 W/mK auf. Niedrige Wärmeleitfähigkeiten sind für Thermoelektrika essentiell. Die elektrischen Leitfähigkeiten im Temperaturbereich ab 400 °C (insbesondere bis 700 °C) liegen für die erfindungsgemäßen Materialien vorzugsweise bei wenigstens 250 S/cm, bevorzugt wenigstens 350 S/cm, insbesondere bei wenigstens 400 S/cm, mehr bevorzugt bei wenigstens 450 S/cm und besonders bevorzugt bei wenigstens 500 S/cm. Eine hohe elektrische Leitfähigkeit trägt zu den guten thermoelektrischen Eigenschaften bei. Eine geringe Bandlücke führt zu guten thermoelektrischen Eigenschaften. Die erfindungsgemäßen Materialien weisen Bandlücken ab 450 °C auf, die insbesondere unterhalb von 0,5 eV, insbesondere unterhalb von 0,3 eV, bevorzugt unterhalb von 0,2 und besonders bevorzugt unterhalb von 0,13 eV liegen.

Die Materialien dieser Erfindung sind vorzugsweise frei von Pb, Bi, Hf, Ge, Te und Yb. Insbesondere sind die Materialien vorzugsweise frei von hierin nicht als Bestandteil genannten Komponenten. Wenn es in dieser Beschreibung heißt, die Materialien seien frei von einer Komponente oder enthalten eine gewisse Komponente nicht, so ist damit gemeint, dass diese Komponente allenfalls als Verunreinigung in den Materialien vorliegen darf. Das bedeutet, dass sie nicht in wesentlichen Mengen zugesetzt wird. Nicht wesentliche Mengen sind erfindungsgemäß Mengen von weniger als 100 ppm (w/w), bevorzugt weniger als 50 ppm und am meisten bevorzugt weniger als 10 ppm.

Erfindungsgemäß ist auch ein Formkörper, der das erfindungsgemäße Material umfasst oder im Wesentlichen aus diesem Material besteht. Der Formkörper weist insbesondere eine Dichte auf, die wenigstens 90%, bevorzugt wenigstens 95% der theoretischen, kristallographischen Dichte des erfindungsgemäßen Materials entspricht. Der Formkörper besteht vorzugsweise zu wenigstens 90% (w/w), bevorzugt zu wenigstens 94%, mehr bevorzugt zu wenigstens 95% aus dem erfindungsgemäßen Material.

Erfindungsgemäß ist auch ein thermoelektrischer Generator, der ein Material und/oder einen Formkörper dieser Erfindung umfasst. Thermoelektrische Generatoren bestehen aus mehreren Komponenten und dienen dazu, die Wärmeenergie aus einem Heizfluid in elektrische Energie umzuwandeln. Eine Wärmequelle, z.B. ein Verbrennungsmotor oder ein Heizungssystem, mit einem Heizfluid mit einem Heizfluideintritt und -austritt überträgt über Wärmetauscher Wärmenergie auf thermoelektrischen Elemente. Gegenüberliegend der Wärmequelle, auf der anderen Seite des thermoelektrischen Elements, wird mit einer Kühlung mit einem Kühlfluid und einem Kühlfluideintritt und -austritt über Wärmetauscher Wärmeenergie entzogen. Aufgrund des Seebeck-Effektes resultiert aus dem Temperaturgefälle eine Spannung, die durch stromführende Leiter als elektrische Energie in Verbraucher (z.B. im Auto) eingespeist werden kann. Üblicherweise dient im Automobil ein Rohr im Abgasstrang als Heizquelle und Verbrennungsgase als Heizfluide, die Kühlung kann z.B. durch einen Wasserkreislauf oder durch Luft erfolgen. Dabei können die thermoelektrischen Elemente in Platten angeordnet sein, durch diese sind die thermoelektrischen Elemente jeweils mit einem Heizfluid und Kühlfluid in Kontakt und können dadurch "modulartig" erweitert werden.

Der erfindungsgemäße thermoelektrische Generator weist insbesondere folgendes auf:
- ein thermoelektrisches Element,
- einen Eintritt und einen Austritt für Heizfluid, um eine Seite des thermoelektrischen Elements zu erwärmen,
- einen Eintritt und einen Austritt für Kühlfluid, um eine andere Seite des thermoelektrischen Elements zu kühlen, und
- wenigstens einen stromführenden Leiter, um die gewonnene elektrische Energie in einen Verbraucher einzuspeisen.

Ein Heizfluid kann auf diese Weise, insbesondere vermittelt durch einen Wärmetauscher, Wärmeenergie auf eine Seite des thermoelektrischen Elements übertragen. Ein Kühlfluid kann auf einer anderen Seite des thermoelektrischen Elements, insbesondere über einen Wärmetauscher, dem System Wärmeenergie entziehen. Das thermoelektrische Element umfasst das thermoelektrische Material dieser Erfindung. Der thermoelektrische Generator kann mehrere thermoelektrische Elemente umfassen.

Der thermoelektrische Generator kann insbesondere in einem Kraftfahrzeug eingesetzt werden. Es sind aber auch andere Einsatzmöglichkeiten erfindungsgemäß. Bevorzugt wird der thermoelektrische Generator in Längsrichtung der Strömungsrichtung der Fluide aufgebaut. Bevorzugt ist hierbei der Einbau in Dichtungen und elektrisches Isolationsmaterial, welche im Temperaturbereich gegenüber den Umgebungsbedingungen und dem thermoelektrischen Material stabil sind. Auch sollten die thermoelektrischen Elemente durch elektrische Kontakte verknüpft werden, die im Temperaturbereich gegenüber dem thermoelektrischen Material stabil sind und nicht in den Formkörper diffundieren.

### Verfahren

Erfindungsgemäß ist auch ein Verfahren zur Herstellung eines thermoelektrischen Materials dieser Erfindung. Das Verfahren umfasst die folgenden Schritte:
- Bereitstellen der Elemente R, Mangan, Kupfer und Phosphor in einem Reaktionsgefäß,
- Evakuieren des Reaktionsgefäßes,
- Erhitzen des Reaktionsgefäßes auf eine Temperatur oberhalb von 700 °C, insbesondere oberhalb von 750 °C, jedoch nicht über 850 °C,
- Entnahme des Reaktionsprodukts.

Es hat sich gezeigt, dass mit dem genannten Verfahren die erfindungsgemäßen thermoelektrischen Materialien in guter Qualität und hoher Ausbeute herstellbar sind. Um einen eventuellen Verdampfungsverlust des Erdalkalimetalls auszugleichen, wird R vorzugsweise in einem Überschuss von 2% bis 20% im Verhältnis zu der stöchiometrisch benötigten Menge eingesetzt.

In einer bevorzugten Ausführungsform wird das Reaktionsgefäß vor dem Schritt des Erhitzens auf eine erhöhte Temperatur vorgewärmt, die unterhalb der Temperatur während des Schrittes des Erhitzens liegt. Während des Vorwärmens wir das Reaktionsgefäß vorzugsweise auf eine Temperatur von wenigstens 300 °C, insbesondere wenigstens 350 °C vorgewärmt. Die Temperatur während des Vorwärmens ist vorzugsweise auf höchstens 600 °C, insbesondere höchstens 500 °C oder höchstens 450 °C begrenzt. Die Temperatur wird vorzugsweise für eine Dauer von wenigstens 10 Stunden, insbesondere wenigstens 20 Stunden und besonders bevorzugt wenigstens 30 Stunden gehalten. Vorzugsweise wird die Temperatur für einen Zeitraum von nicht mehr als 150 Stunden, insbesondere nicht mehr als 80 Stunden und besonders bevorzugt nicht mehr als 50 Stunden gehalten. Das Vorwärmen erfolgt insbesondere mit einer Aufheizrate von wenigstens 20 °C/h, mehr bevorzugt wenigstens 30 °C/h und besonders bevorzugt wenigstens 40 °C/h. Die Aufheizrate sollte allerdings bevorzugt eine Rate von 250 °C/h, insbesondere 150 °C und besonders bevorzugt 80 °C/h nicht überschreiten. Das Vorwärmen führt dazu, dass die Elemente schon zum Teil bei niedrigen Temperaturen reagieren um den "Verlust" von z.B. Magnesium bei höheren Temperaturen zu begrenzen. Weiter soll das Element Phosphor möglichst bei diesen niedrigen Temperaturen Phosphide mit den anderen Elementen bilden. Zusammengefasst soll so die Synthese von Nebenphasen (Verbindungen, die nicht gewünscht sind, im Falle von MgCuP z.B. Cu₃P und Mg₃P₂) verhindert werden.

Erfindungsgemäß wird das Reaktionsgefäß im Schritt des Erhitzens nicht über 850 °C erhitzt. Bei zu hohen Temperaturen bilden sich unerwünschte Nebenprodukte. Um eine vollständige Umsetzung der Rohstoffe zu gewährleisten, hat es sich als vorteilhaft erwiesen, die genannte hohe Temperatur für eine Dauer von wenigstens 30 Stunden, insbesondere wenigstens 40 Stunden oder wenigstens 50 Stunden aufrecht zu erhalten. Vorzugsweise wird die Temperatur für einen Zeitraum von nicht mehr als 250 Stunden, insbesondere nicht mehr als 150 Stunden und besonders bevorzugt nicht mehr als 100 Stunden gehalten. Das Erhitzen erfolgt insbesondere mit einer Aufheizrate von wenigstens 20 °C/h, mehr bevorzugt wenigstens 30°C/h und besonders bevorzugt wenigstens 40°C/h. Die Aufheizrate sollte allerdings bevorzugt eine Rate von 250 °C/h, insbesondere 150 °C und besonders bevorzugt 80 °C/h nicht überschreiten. Wenn die genannten Bedingungen nicht eingehalten werden, besteht die Gefahr der Bildung von Nebenphasen. Bei hohen Temperaturen besteht die Gefahr, dass sich die Verbindung im Vakuum zersetzt in z.B. Cu₃P, oder andere Verbindungen. Bei zu niedrigen Temperaturen verläuft die Reaktion nicht vollständig zum gewünschten Produkt und es bleibt z.B. elementares Kupfer in der Reaktionsmischung, das gleiche gilt falls die Reaktionszeit zu kurz ist. Bei einer zu langen Reaktionszeit könnte es passieren, dass sich die Verbindung (ähnlich wie bei einer zu hohen Temperatur) allmählich zersetzt. Bei einer zu schnellen Aufheizrate können Nebenphasen entstehen, da z.B. die Elemente Magnesium und Phosphor verdampfen, bevor sie reagieren können.

An den Schritt des Erhitzens schließt sich insbesondere ein Schritt des Abkühlens an. Das Abkühlen erfolgt vorzugsweise mit einer Abkühlrate von nicht mehr als 1000 °C/h, bevorzugt nicht mehr als 500°C/h, mehr bevorzugt nicht mehr als 300°C und besonders bevorzugt nicht mehr als 150°C/h. Die Abkühlrate beträgt vorzugsweise mindestens 10°C/h, mehr bevorzugt wenigstens 30°C/h, weiter bevorzugt wenigstens 50°C/h und besonders bevorzugt wenigstens 70°C/h. Bei zu schnellem Abkühlen ist das Produkt nicht sehr kristallin, was die Identifikation von eventuell vorhandenen Nebenphasen mittels Röntgenbeugung erschwert. Ein zu langsames Abkühlen führt zu einer deutlichen Erhöhung der Reaktionszeit.

Optional schließt sich an die Entnahme des Reaktionsprodukts ein Schritt des Zerkleinerns, z.B. Mahlens, des Reaktionsprodukts an. Nach dem Zerkleinern kann aus dem Reaktionsprodukt ein Formkörper hergestellt werden. Daher ist ein weiterer optionaler Schritt das Verdichten des Reaktionsprodukts zu einem Formkörper im Anschluss an die Entnahme und/oder im Anschluss an das Zerkleinern des Reaktionsprodukts. Der Formkörper weist vorzugsweise eine Dichte auf, die wenigstens 90%, insbesondere wenigstens 95%, der theoretischen, kristallographischen Dichte des Materials beträgt. Es hat sich gezeigt, dass das thermoelektrische Material dieser Erfindung auch bei Verdichtung keine Veränderung der Kristallstruktur erfährt, so dass es sich sehr gut zu Formkörpern verarbeiten lässt.

Das Verdichten kann insbesondere mittels SPS *(spark plasma sintering)* erfolgen, es sind aber auch andere, dem Fachmann geläufige Verfahren möglich. Vorzugsweise wird das Reaktionsprodukt nach der Entnahme und ggf. nach dem Zerkleinern in eine Form, z.B. eine Graphit-Matrize, überführt. Vorzugsweise wird das Reaktionsprodukt in der Form auf eine Temperatur von wenigstens 300°C, insbesondere wenigstens 350°C erwärmt. Die Temperatur während des Erwärmens ist vorzugsweise auf höchstens 600°C, insbesondere höchstens 500°C oder höchstens 450°C begrenzt. Das Erwärmen erfolgt insbesondere mit einer Aufheizrate von wenigstens 20°C/h, mehr bevorzugt wenigstens 30°C/h und besonders bevorzugt wenigstens 40°C/h. Die Aufheizrate sollte allerdings bevorzugt eine Rate von 250°C/h, insbesondere 150°C und besonders bevorzugt 80°C/h nicht überschreiten. Das Verdichten erfolgt, insbesondere im Anschluss an das Erwärmen, durch Pressen mit einem Druck von vorzugsweise wenigstens 10 MPa, insbesondere wenigstens 20 MPa und bevorzugt wenigstens 25 MPa. Der Druck sollte allerdings nicht über 150 MPa, bevorzugt nicht über 100 MPa und besonders bevorzugt nicht über 50 MPa steigen. Vorzugsweise wird während des Pressens weiter erwärmt, insbesondere auf eine Temperatur von wenigstens 500°C, insbesondere wenigstens 610°C erwärmt. Die Temperatur während des Pressens ist vorzugsweise auf höchstens 850°C, insbesondere höchstens 800°C oder höchstens 750°C begrenzt. Diese Temperatur wird während des Pressens für eine Dauer von insbesondere wenigstens 10 Minuten, bevorzugt wenigstens 20 Minuten und besonders bevorzugt wenigstens 25 Minuten gehalten. Vorzugsweise wird diese Temperatur für eine Dauer von nicht mehr als 2 Stunden, insbesondere nicht mehr als 1 Stunde und besonders bevorzugt nicht mehr als 45 Minuten gehalten. Anschließend wird der erhaltene Formkörper abgekühlt, insbesondere ohne weitere Ausübung eines Druckes. Es hat sich gezeigt, dass die Formkörper zerspringen können, wenn während des Abkühlens weiter Druck ausgeübt wird. Wird zu kalt gearbeitet oder ist die Verdichtungszeit zu kurz, ist die Verdichtung nicht hoch genug, d.h. der Formkörper besitzt weniger als 90% der theoretischen, kristallographischen Dichte Teilweise ist der Formkörper nicht stabil und zerbricht in kleinere Teile. Wird zu heiß unter Druck gearbeitet, entstanden teilweise Nebenphasen. Bei der Form kann es sich um einen Hohlzylinder handeln, insbesondere mit zwei vorzugsweise passgenauen Stempeln.

Das erfindungsgemäße Herstellungsverfahren macht das erfindungsgemäße Material mit hoher Ausbeute und Reinheit erhältlich. Das Verfahrensprodukt besteht insbesondere zu wenigstens 90% (w/w), bevorzugt zu wenigstens 94%, mehr bevorzugt zu wenigstens 95% aus dem erfindungsgemäßen Material.

### Verwendung

Erfindungsgemäß ist auch die Verwendung des hierin beschriebenen Materials als Thermoelektrikum. Dies schließt die Verwendung des Materials in einem thermoelektrischen Generator ein. In bevorzugten Ausführungsformen wird das Material als Thermoelektrikum zur Gewinnung von elektrischer Energie aus Abwärme eingesetzt, insbesondere in einem Kraftfahrzeug (z.B. im Abgasstrang).

### Figuren

Es zeigen
- FIG.1: das Ergebnis einer DSC/TG-Messung an Mg_{0,90}Mn_{0,10}CuP;
- FIG.2: zeigt die Seebeck-Koeffizienten der synthetisierten Verbindungen in Abhängigkeit von der Temperatur;
- FIG.3: zeigt die elektrische Leitfähigkeit der synthetisierten Verbindungen in Abhängigkeit von der Temperatur;
- FIG.4: zeigt die Wärmeleitfähigkeit der synthetisierten Verbindungen in Abhängigkeit von der Temperatur;
- FIG.5: zeigt die zT-Faktoren der synthetisierten Verbindungen in Abhängigkeit von der Temperatur;

### Beispiele

### Synthese und röntgendiffraktometrische Charakterisierung

Alle hier diskutierten Verbindungen wurden in evakuierten Quarzglasampullen mit Korundinnentiegeln synthetisiert. Die Elemente Magnesium, Mangan, Kupfer und Phosphor wurden im Verhältnis (1,15 - x): x : 1 : 1 (x = 0,05; 0,1; 0,15; 0,2) eingewogen und im Argon-Gegenstrom in den Innentiegel in einer vorher ausgeheizten Halbampulle überführt. Ein Überschuss an Magnesium wurde eingesetzt, da sich bei der Reaktionstemperatur Magnesium verflüchtigt und einen hellen Niederschlag an der Quarzglaswand der Ampulle bildet. Die Einwaagen der Elemente für die ternäre und die quaternären Verbindungen sind Tabelle 1 zu entnehmen. Alle Ansätze wurden so berechnet, dass jeweils ca. ein Gramm des gewünschten Produktes erhalten wurde.

**Tabelle 1**

| **Zielverbindung** | **m Mg / g** | **m Mn / g** | **m Cu / g** | **m P / g** |
|---|---|---|---|---|
| MgCuP | 0,2054 | 0 | 0,5438 | 0,2608 |
| Mg_{0,95}Mn_{0,05}CuP | 0,2285 | 0,024 | 0,5434 | 0,2668 |
| Mg_{0,90}Mn_{0,10}CuP | 0,193 | 0,043 | 0,5055 | 0,2463 |
| Mg_{0,85}Mn_{0,15}CuP | 0,2018 | 0,0646 | 0,5065 | 0,2439 |
| Mg_{0,80}Mn_{0,20}CuP | 0,1933 | 0,0988 | 0,5613 | 0,2742 |

Die evakuierten Ampullen wurden verschlossen und einem Temperaturprogramm in einem Rohrofen unterworfen. Zuerst wurde mit 50°C/h auf 400 °C erhitzt und diese Temperatur 36 Stunden gehalten, anschließend mit 50°C/h auf 850 °C erhitzt und 72 Stunden gehalten und dann wurde mit einer Abkühlrate von 100°C/h auf Raumtemperatur abgekühlt. Temperaturen von mehr als 850 °C führten zur Bildung von Cu₃P und Mg₃P₂ als Nebenphasen. Ein größerer Überschuss von Magnesium führte zu Bildung von Mg₂Cu. Die erhaltenen Präparate von Mg_{1-*x*}Mn*ₓ*CuP erwiesen sich als nicht luft- oder feuchtigkeitsempfindlich.

Alle Produkte wurden gemahlen und pulverdiffraktometrisch (Cu_{*Kα*,1}-Strahlung) untersucht. Auf Basis des bekannten Strukturmodells von MgCuP wurden für alle Verbindungen Rietveld-Anpassungen vorgenommen. Substituierte Produkte mit x = 0,05; 0,10 und 0,15 wurden fast phasenrein mit nur geringen Anteilen an Nebenphasen erhalten. Wenn Mg durch Mn mit x = 0,20 substituiert werden sollte, erhielt man mehrphasige Produkte mit größeren Anteilen an Cu₃P als Nebenphase.

### Verdichtung

Die Verdichtung erfolgte mittels SPS für die Mischkristallreihe Mg_{1-*x*}Mn*ₓ*CuP. Jeweils ca. 0,6 bis 0,8 g der Proben wurden fein verrieben und in eine Graphit-Matrize mit 10 mm Innendurchmesser gegeben. Die Pressparameter wurden durch eine Vielzahl an Versuchen ermittelt.

Hoch verdichtete Probenkörper wurden wie folgt erhalten. Ohne Druck wurde zuerst mit ca. 50°C/min bis ca. 400 °C erwärmt. Dann wurde ein Druck von 30 MPa (entspricht 2,3 kN) angelegt und weiter erwärmt. Bei 650°C wurde der Druck auf 50 MPa (entspricht 3,7 kN) erhöht und bei konstanter Temperatur für einen Zeitraum von einer halben Stunde gehalten. Nach Beendigung der Verdichtung und Herunterfahren der Leistung der SPS-Apparatur wurde kein Druck auf den Probenkörper ausgeübt. Bei vielen Verdichtungsversuchen im Rahmen dieser Arbeit wurde festgestellt, dass die Probenkörper intermetallischer Phasen zerbrechen können, wenn während der Abkühlphase Druck auf sie ausgeübt wird.

Nachdem die Proben abgekühlt waren, wurden die Graphit-Matrizen entnommen. Die Proben wurden mit Hilfe eines Schraubstocks aus den Matrizen entfernt, da sie sich nur schwer aus der Graphit-Matrize lösen ließen. Die verdichteten Probenkörper wurden sorgfältig mit Schleifpapier mechanisch behandelt, um eventuell vorhandenes Graphit zu entfernen und um eine gute Kontaktierung der Probenkörper in den Geräten zur Bestimmung der thermoelektrischen Eigenschaften zu gewährleisten. Die Dichten der Proben wurden pyknometrisch bestimmt. Dabei wurden Werte von >95% der theoretischen, kristallographischen Dichte ermittelt.

Die erhaltenen verdichteten Probenkörper der festen Lösung Mg_{1-*x*}Mn*ₓ*CuP wurden mit Röntgenbeugung in Reflexion untersucht, um zu überprüfen, ob durch die Verdichtung Veränderungen an der Probe entstanden waren. Aus Diffraktogrammen war ersichtlich, dass durch die Verdichtung keine Veränderungen der Kristallstruktur verursacht worden sind. Die Proben zeigten nach Verdichtung keine Veränderung der Identität.

### Thermoanalyse

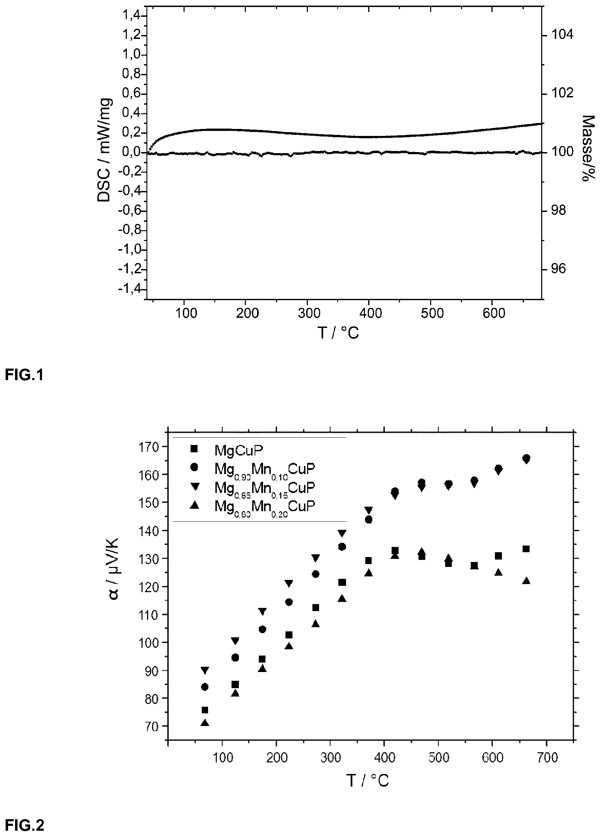

Die Verbindung Mg_{0,90}Mn_{0,10}CuP wurden mittels DSC/TG thermoanalytisch untersucht (Figur 1). Die Messung wurde unter Argon in Platintiegeln mit Korundinnentiegeln von 25°C bis 700°C mit einer Heizrate von 10°C/min durchgeführt. Es sind keine Änderungen der Masse oder Peaks zu erkennen, die auf eine physikalische oder chemische Umwandlung der Verbindung hinweisen. Die Verbindung ist also thermostabil.

### Energiedispersive Spektroskopie

Verdichtete Probenkörper der Verbindungen MgCuP, Mg_{0,90}Mn_{0,10}CuP, Mg_{0,85}Mn_{0,15}CuP und Mg_{0,80}Mn_{0,20}CuP wurden mittels energiedispersiver Röntgenspektroskopie hinsichtlich ihrer Zusammensetzung und der Verteilung der Elemente untersucht. Die Messungen zeigten, dass die Substitution von Mangan für Magnesium zu einem geringeren Anteil an Mangan als durch Einwaage vorgesehen geführt hat. In Tabelle 2 sind die mittels energiedispersiver Spektroskopie (EDS) ermittelten Anteile im Vergleich zu den durch die Einwaage vorgesehenen Anteilen aufgeführt. Für alle Verbindungen wurde jeweils ein geringerer Anteil an Mangan ermittelt, als durch die Einwaage vorgesehen war. Dies ist konsistent mit den Gitterparametern und Besetzungsfaktoren, die mittels Rietveld-Methode ermittelt wurden. Der Grund dafür ist, dass das Einwaageverhältnis zwischen Magnesium und Mangan nicht ideal war; es ist ein Überschuss Magnesium eingesetzt worden, da Magnesium teilweise während der Reaktion verdampft. Daher ist das Verhältnis zwischen Magnesium im Falle der beabsichtigten Verbindung Mg_{0,90}Mn_{0,10}CuP nicht exakt 0,9 zu 0,1.

**Tabelle 2**

| **Ideal** | **x (EDS)** |
|---|---|
| Mg_{0,90}Mn_{0,10}CuP | 0,089 |
| Mg_{0,85}Mn_{0,15}CuP | 0,101 |
| Mg_{0,80}Mn_{0,20}CuP | 0,182 |

### Thermoelektrische Charakterisierung

Alle synthetisierten und verdichteten Verbindungen im System Mg_{1-*x*}Mn*ₓ*CuP wurden thermoelektrisch charakterisiert. Die Messungen der Seebeck-Koeffizienten und der elektrischen Leitfähigkeiten wurden simultan von 50°C bis 650°C bzw. 800°C durchgeführt. In einer weiteren Messung wurden mit der Laserflash-Methode die Temperatur- und Wärmleitfähigkeiten bestimmt.

Die Messungen der Seebeck-Koeffizienten (Figur 2) zeigen, dass MgCuP und die quaternären Verbindungen p-Thermoelektrika sind. Der Verlauf der Seebeck-Koeffizienten ist für alle Verbindungen ähnlich. Zuerst steigen die Seebeck-Koeffizienten stark bis ca. 450°C an. Bei höheren Temperaturen sind Unterschiede in den verschiedenen Verbindungen zu erkennen. Mg_{0,90}Mn_{0,10}CuP und Mg_{0,85}Mn_{0,15}CuP zeigen weiter steigende Seebeck-Koeffizienten, die kein Maximum aufweisen und einen Wert von 165 µV/K bei 680 °C aufweisen. Für MgCuP und Mg_{0,80}Mn_{0,20}CuP sind sinkende Seebeck-Koeffizienten zu erkennen. Allerdings steigt der Seebeck-Koeffizient von MgCuP bei Temperaturen über 600 °C erneut an.

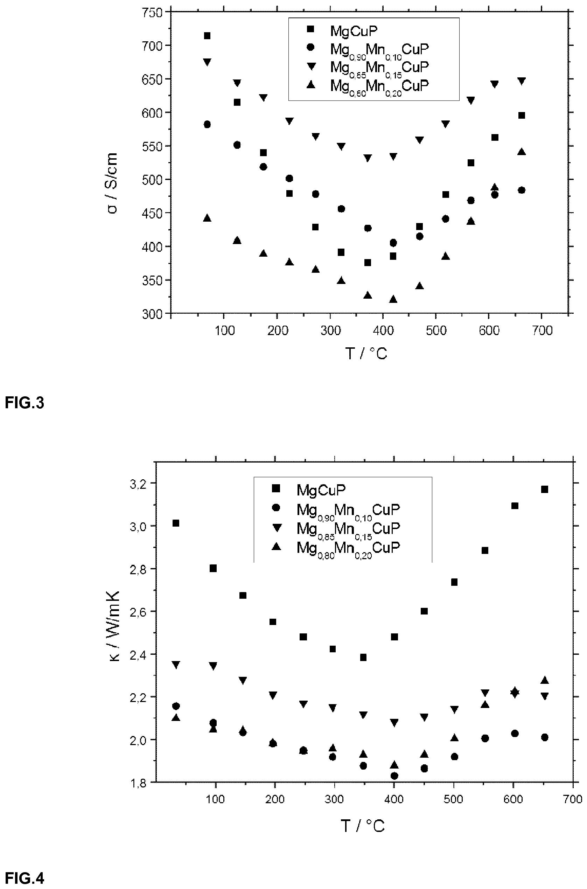

Die Änderungen im Verlauf der Seebeck-Koeffizienten bei 550°C korrespondieren mit dem Verlauf der elektrischen Leitfähigkeiten. Bei niedrigen Temperaturen bis ca. 300°C zeigen alle Verbindungen metallisches Verhalten. Alle Verbindungen weisen dann in einem Bereich zwischen 300°C und 400°C einen Übergang von metallischem Verhalten zu Halbleiterverhalten auf. Dies ist in Figur 3 gezeigt. Die elektrischen Leitfähigkeiten verschiedener Proben verlaufen ähnlich. Der Anteil von Mangan in Mg_{1-*x*}Mn*ₓ*CuP korrespondiert nicht mit den Größen der elektrischen Leitfähigkeiten.

Mit einer Arrhenius-Auftragung der natürlichen Logarithmen der elektrischen Leitfähigkeiten gegen die reziproke Temperatur wurden die Bandlücken der Verbindungen im Temperaturbereich ab 450°C bestimmt (Tabelle 3). Mg_{0,90}Mn_{0,10}CuP und Mg_{0,85}Mn_{0,15}CuP besitzen Bandlücken, die mit ca. 0,1 eV geringer sind als die Bandlücken von MgCuP und Mg_{0,80}Mn_{0,20}CuP.

**Tabelle 3**

| **Ideal** | **Bandlücke / eV** |
|---|---|
| MgCuP | 0,2 |
| Mg₀,₉₀Mn_{0,10}CuP | 0,1 |
| Mg_{0,85}Mn_{0,15}CuP | 0,09 |
| Mg_{0,80}Mn_{0,20}CuP | 0,28 |

Die Wärmeleitfähigkeiten von Mg_{1-*x*}Mn*ₓ*CuP wurden auf Basis der mittels DSC ermittelten Wärmekapazitäten von Mg_{0,90}Mn_{0,10}CuP berechnet (Figur 4). Alle Verbindungen zeigen deutliche Änderungen bei einer Temperatur von ca. 400°C. Bis 400°C sinken die Wärmeleitfähigkeiten, über 400°C steigen die Wärmeleitfähigkeiten an. MgCuP zeigt mit Werten von 2,4 bis 3,2 W/mK die höchsten Wärmeleitfähigkeiten. Mg_{0,90}Mn_{0,10}CuP und Mg_{0,85}Mn_{0,15}CuP weisen die niedrigsten Werte auf, welche über 600°C näherungsweise konstant sind. Die Substitution von Mn für Mg hat zu niedrigeren Wärmeleitfähigkeiten geführt.

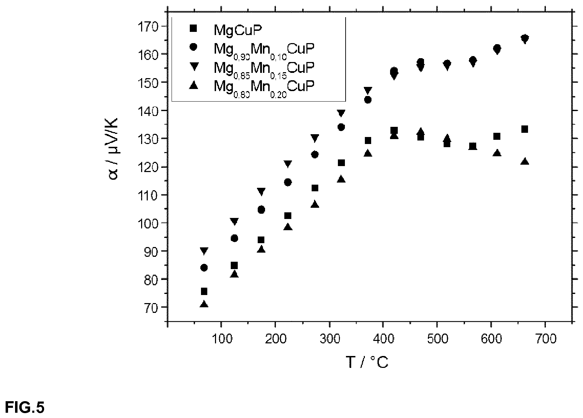

Die hohen Seebeck-Koeffizienten, die vergleichsweise hohen elektrische Leitfähigkeiten und die niedrigen Wärmeleitfähigkeiten führen zu hohen thermoelektrischen Gütezahlen (zT-Faktoren), die mit der Temperatur ansteigen (Figur 5). Alle Verbindungen weisen kein Maximum des zT-Faktors auf. MgCuP und Mg_{0,80}Mn_{0,20}CuP weisen zT-Werte von ca. 0,3 bei 650°C auf. Durch die Substitution von Mg durch Mn wurde eine signifikante Verbesserung der thermoelektrischen Eigenschaften erreicht. Mg_{0,90}Mn_{0,10}CuP und Mg_{0,85}Mn_{0,15}CuP besitzen mit zT-Werten über 0,6 Gütefaktoren, die vergleichbar sind mit den zT-Werten von den besten bisher in der Literatur beschriebenen Phosphiden.

## Patentansprüche

1. Thermoelektrisches Material mit der Formel R₁₋ₓMnₓCuP, wobei x wenigstens 0,01 und höchstens 0,99 beträgt und R ausgewählt ist aus Mg, Ca, Ba, Sr und Mischungen daraus.

2. Material nach Anspruch 1, wobei x nicht mehr als 0,5 beträgt, insbesondere nicht mehr als 0,3 oder nicht mehr als 0,2.

3. Material nach Anspruch 1 oder 2, wobei x wenigstens 0,02 beträgt, insbesondere wenigstens 0,03 oder wenigstens 0,08.

4. Material nach einem der Ansprüche 1 bis 3, wobei R = Mg ist.

5. Verfahren zur Herstellung des Materials nach einem der Ansprüche 1 bis 4, umfassend die folgenden Schritte:
- Bereitstellen der Elemente R, Mangan, Kupfer und Phosphor in einem Reaktionsgefäß,
- Evakuieren des Reaktionsgefäßes,
- Erhitzen des Reaktionsgefäßes auf eine Temperatur oberhalb von 700 °C, jedoch nicht über 850 °C,
- Entnahme des Reaktionsprodukts.

6. Verfahren nach Anspruch 5, mit dem weiteren Schritt
- Zerkleinern, insbesondere Mahlen, des Reaktionsprodukts im Anschluss an die Entnahme.

7. Verfahren nach einem der Ansprüche 5 oder 6, wobei das Reaktionsgefäß für einen Zeitraum von wenigstens 50 Stunden und höchstens 100 Stunden bei einer Temperatur von mehr als 700 °C gehalten wird.

8. Verfahren nach wenigstens einem der Ansprüche 5 bis 7, mit dem weiteren Schritt
- Verdichten des Reaktionsprodukts zu einem Formkörper im Anschluss an die Entnahme.

9. Verwendung eines Materials nach einem der Ansprüche 1 bis 4, als Thermoelektrikum.

## Claims

1. A thermoelectric material having the formula R₁₋ₓMnₓCuP, wherein x is at least 0.01 and at most 0.99 and R is selected from Mg, Ca, Ba, Sr and mixtures thereof.

2. The material according to claim 1, wherein x is not higher than 0.5, in particularly not higher than 0.3 or not higher than 0.2.

3. The material according to claim 1 or 2, wherein x is at least 0.02, in particularly at least 0.03 or at least 0.08.

4. The material according to one of claims 1 to 3, wherein R = Mg.

5. A method for the production of the material according to one of claims 1 to 4, comprising the following steps:
- providing of the elements R manganese, copper and phosphorus in a reaction vessel,
- evacuating of the reaction vessel,
- heating of the reaction vessel to a temperature of above 700 °C, however not higher than 850 °C,
- removal of the reaction product.

6. The method according to claim 5, with the further step
- comminuting, in particularly grinding, of the reaction product subsequent to the removal.

7. The method according to one of claims 5 or 6, wherein the reaction vessel is kept at a temperature of higher than 700 °C for a period of time of at least 50 hours and at most 100 hours.

8. The method according to at least one of claims 5 to 7, with the further step
- compacting of the reaction product to a molded body subsequent to the removal.

9. A use of a material according to one of claims 1 to 4, as thermoelectric.

## Revendications

1. Matériau thermoélectrique de formule R₁₋ₓMnₓCuP, x valant au moins 0,01 et au plus 0,99 et R étant choisi parmi Mg, Ca, Ba, Sr et leurs mélanges.

2. Matériau selon la revendication 1, dans lequel x vaut au plus 0,5, en particulier au plus 0,3 ou au plus 0,2.

3. Matériau selon la revendication 1 ou 2, dans lequel x vaut au moins 0,02, en particulier au moins 0,03 ou au moins 0,08.

4. Matériau selon l'une des revendications 1 à 3, dans lequel R = Mg.

5. Procédé de fabrication du matériau selon l'une des revendications 1 à 4, comprenant les étapes suivantes :
- fournir des éléments R, manganèse, cuivre et phosphore dans un réacteur,
- faire le vide dans le réacteur,
- chauffer le réacteur à une température supérieure à 700 °C, mais pas supérieure à 850 °C,
- retirer le produit de réaction.

6. Procédé selon la revendication 5, comprenant en outre l'étape suivante
- pulvériser, notamment broyer, le produit de réaction après le retrait.

7. Procédé selon l'une des revendications 5 ou 6, dans lequel le réacteur est maintenu à une température supérieure à 700 °C pendant une durée d'au moins 50 heures et d'au plus 100 heures.

8. Procédé selon au moins l'une des revendications 5 à 7, comprenant l'étape supplémentaire suivante
- compresser le produit de réaction pour former un corps moulé après le retrait.

9. Utilisation d'un matériau selon l'une des revendications 1 à 4 comme matériau thermoélectrique.
